# EUROPÄISCHE PATENTSCHRIFT

(11) **EP 0 686 225 B1**
(45) Veröffentlichungstag und Bekanntmachung des Hinweises auf die Patenterteilung: **26.03.1997**
(21) Anmeldenummer: 94901768.5
(22) Anmeldetag: 17.12.1993
(51) Int. Cl.: E05F 15/16

(54) **GEHÄUSE ZUM AUFNEHMEN VON ELEKTRISCHEN ANTRIEBEN**
HOUSING FOR ELECTRIC-DRIVE UNITS
BOITIER POUR SYSTEMES D'ENTRAINEMENT ELECTRIQUES

(30) Priorität: 14.01.1993 DE 9300400 U
(43) Veröffentlichungstag der Anmeldung: 13.12.1995
(73) Patentinhaber: ROBERT BOSCH GMBH, 70442 Stuttgart (DE)
(72) Erfinder: KAISER, Norbert, D-70567 Stuttgart (DE); SIEGWART, Bernhard, D-71679 Asperg (DE); GRABANDT, Peter, D-71686 Remseck (DE); SPAETH, Matthias, D-71696 Möglingen (DE)
(86) Internationale Anmeldenummer: DE9301209
(87) Internationale Veröffentlichungsnummer: WO9416184

(56) Entgegenhaltungen:
- DE-A- 3 444 143
- DE-A- 3 838 285
- US-A- 4 491 752

## Beschreibung

### Stand der Technik

Die Erfindung betrifft eine Gehäuse zum Aufnehmen von elektrischen Antrieben, insbesondere von Garagentorantrieben, nach dem Oberbegriff des Hauptanspruchs. Ein derartiges Gehäuse, wie es beispielsweise aus der DE-PS 30 12 465 oder der DE-PS 37 26 685 bekannt ist, nimmt einerseits Baugruppen, wie Elektromotor und Getriebe, Netzteil, Schaltungsplatinen oder Beleuchtungseinrichtungen, auf und stellt andererseits ein Bindeglied zwischen den die Kraft übertragenden Elementen und der statischen Peripherie dar, beispielsweise einer Garagendecke oder einem Garagentor. Ein solches Gehäuse muß deshalb robust aufgebaut sein und genügend Platz und Befestigungsmöglichkeiten für die einzelnen Baugruppen aufweisen.

Aus der DE-OS 32 03 577 ist es bekannt, den Antrieb auf einem Träger zu befestigen und mittels einer an den Träger angeschraubten Schutzhaube abzudecken.

Da Systeme mit Gehäusen der eingangs genannten Art im freien Handel vertrieben werden und somit von jedermann erworben und montiert werden können, soll ein Gehäuse bereitgestellt werden, welches eine einfache und sichere Montage des Gesamtsystems ermöglicht, die einzelnen Baugruppen platzsparend aufnimmt, sich ohne Spezialwerkzeug zusammensetzen läßt und natürlich den geltenden Sicherheitsvorschriften genügt.

### Vorteile der Erfindung

Das erfindungsgemäße Gehäuse mit den kennzeichnenden Merkmalen des Anspruchs 1 erleichtert den Zusammenbau dadurch, daß das Gehäuse selbst und die vom Gehäuse aufzunehmenden Funktionsbauteile, wie Netzteil, Beleuchtungseinrichtung u.ä. einfach eingesteckt werden können und dann durch selbstschließende Rastmittel arretiert sind. Diese können im Bedarfsfall ebenso einfach wieder demontiert werden.

Durch die Form und Größe der Rastmittel, die an die Geometrie der entsprechenden Funktionsbauteile angepaßt sein müssen, ist ein fehlerhaftes Einsetzen der Funktionsbauteile in das Gehäuse wirkungsvoll vermieden. Ferner kann die Anzahl der zusätzlichen Befestigungsmittel, wie beispielsweise Schrauben, Nieten, Klemmen u.ä., die einzeln gehandhabt werden müssen und verloren gehen können, erheblich reduziert werden.

Durch die in den Unteransprüchen aufgeführten Merkmale sind weitere, vorteilhafte Ausgestaltungen des Gehäuses nach dem Hauptanspruch möglich. Eine besonders einfache Montage bzw. Demontage ist möglich, wenn die Rastmittel innerhalb des Gehäuses ineinandergreifen und mindestens ein Gehäuseteil Öffnungen im Bereich der Rastmittel aufweist, durch die diese mittels eines Werkzeugs entriegelbar sind. Hierzu ist kein Spezialwerkzeug, sondern lediglich ein Werkzeug mit einem schlanken Schaft erforderlich.

Sind an dem die Funktionsbauteile aufnehmenden Gehäuseteil federnde Elemente angeformt, die die Funktionsbauteile im eingebauten Zustand gegen die Rastelemente drücken, ist ein sicherer Halteverbund gewährleistet. Außerdem können Größentoleranzen ausgeglichen werden. Beim Einbau eines Transformators kann das Lamellenpaket zwischen die Rastmittel und die federnde Elemente eingespannt und auf diese Weise eine Vibrationslärm vermieden werden.

Besonders vorteilhaft ist es, wenn ein Gehäuseteil einen lichtdurchlässigen, mit dem Gehäuseteil drehbar oder schwenkbar verbundenen und einrastbaren Deckel aufweist, durch den das Leuchtmittel einer Beleuchtungsvorrichtung auswechselbar ist. Dieser Deckel kann Teil des Gehäuseteils und mit diesem über eine definierte Knickstelle, ein sogenanntes Filmscharnier, beweglich und unverlierbar verbunden sein. Dadurch ist erreicht, daß beim Ausfall der Beleuchtungsvorrichtung nicht das komplette Gehäuseteil demontiert werden muß.

Als weitere Funktionsbauteile kann ein Gehäuseteil Endschalter in Form von Drahtschlaufen aufnehmen, die dann in das Gehäuseteil einrastbar und mit einer in dem Gehäuseteil angeordneten Platine direkt verbindbar sind. Auch hier wird der Montage- und Demontageaufwand sowie die Anzahl der Einzelteile durch die rastbare Verbindung erheblich reduziert. Ferner können die Drahtschlaufen des Endschalters beim Schließen des Kontaktes eine reibende Bewegung ausführen und sich auf diese Weise selbst reinigen, wodurch ein sicherer Kontakt gewährleistet ist.

Weist das Gehäuse Aussparungen für nach außen geführte, auch bei geschlossenem Gehäuse erreichbare Anschlüsse auf, können weitere Funktionsbauteile im Gehäuse aufgenommen und elektrisch sicher deren Funktion außerhalb des Gehäuses ausgenützt werden. Hier ist es beispielsweise möglich, bei einem Garagentorantrieb im Gehäuse ein Batterieladegerät anzuordnen und über den nach außen geführten Anschluß im Bedarfsfall mit der Autobatterie zu verbinden.

### Zeichnung

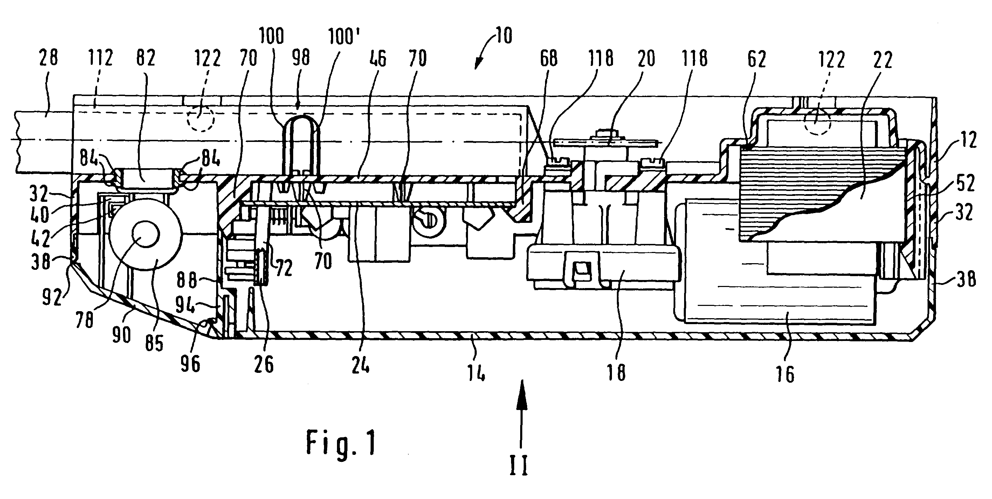

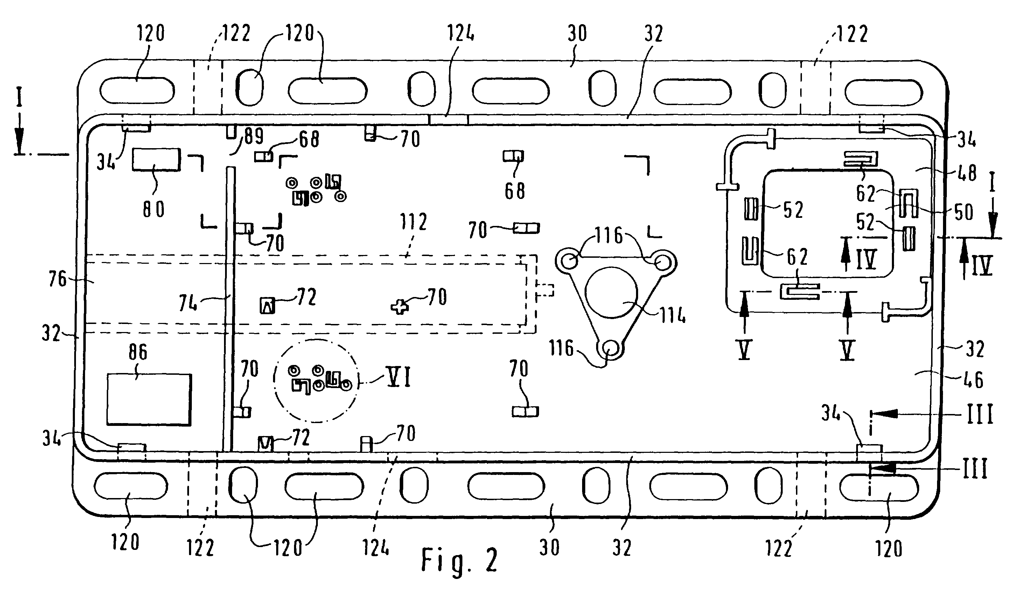

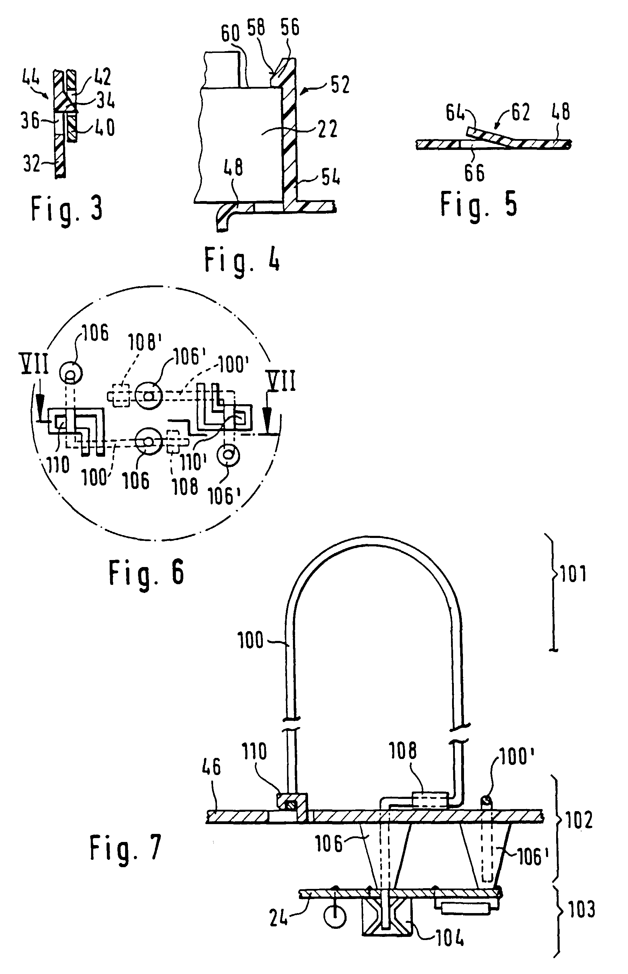

In der Zeichnung ist ein Ausführungsbeispiel eines Gehäuses für einen Garagentorantrieb aufgezeigt und in der nachfolgenden Beschreibung unter Angabe weiterer Vorteile näher erläutert. Es zeigen Figur 1 ein Gehäuse mit eingesetzten Funktionsbauteilen, in einer Seitenansicht im Schnitt gemäß Linie I-I in Figur 2, Figur 2 eine Ansicht eines Gehäuseteils gemäß dem Pfeil II in Figur 1 ohne eingesetzte Funktionsbauteile, Figur 3 einen Schnitt gemäß Linie III-III, Figur 4 einen Schnitt gemäß Linie IV-IV und Figur 5 einen Schnitt gemäß Linie V-V jeweils in Figur 2, Figur 6 einen vergrößerten Ausschnitt der Einzelheit VI in Figur 2 und Figur 7 einen Schnitt gemäß Linie VII-VII in Figur 6. Die Figuren 3 bis 7 sind jeweils mit den entsprechenden Funktionsbauteilen gezeichnet.

### Beschreibung der Ausführungsbeispiele

Das in Figur 1 dargestellte Gehäuse 10 weist ein erstes Gehäuseteil 12 und ein zweites Gehäuseteil 14 auf und nimmt einen elektrischen Motor 16 samt Getriebe 18 und Kettenritzel 20 sowie einen Transformator 22, Schaltungsplatinen 24 und 26 und eine Halteschiene 28 eines Garagentorantriebs auf. Das erste Gehäuseteil 12, das in Figur 2 ohne jegliche Baugruppe und ohne das zweite Gehäuseteil 14 dargestellt ist, besitzt einen Sockel 30 und einen dazu senkrechten, etwas schmäleren kastenförmigen Aufbau mit Wänden 32. An vier voneinander entfernt liegenden Stellen besitzen die Wände 32 nach innen vorspringende, nasenförmige Erhebungen 34 und direkt darunter Öffnungen 36, wie in Figur 3 dargestellt.

Das zweite Gehäuseteil 14 weist Wände 38 auf mit vier laschenförmigen Fortsätzen 40, die jeweils eine Öffnung 42 besitzen. In Zusammenbaustellung korrespondieren die laschenförmige Fortsätze 40 mit den nasenförmigen Erhebungen 34, wobei bei geschlossenem Gehäuse 10 die Erhebungen 34 in die Öffnungen 42 der Fortsätze 40 einrasten.

Zur Demontage der Gehäuseteile 12 und 14 muß mit einem schlanken Werkzeug von der Außenseite 44 durch die jeweilige Öffnung 36 jeder Fortsatz 40 nach innen gebogen und über die Erhebungen 34 gehoben werden. Auf diese Weise kann das Gehäuse zwar einfach aber nicht ohne Werkzeug geöffnet werden, wobei das Werkzeug selbst lediglich einen schlanken Schaft besitzen muß.

Das erste Gehäuseteil 12 weist einen Boden 46 auf, in den eine stufenförmige Vertiefung 48, 50 (aus der Sicht der Figur 2) eingeformt ist, die den Transformator 22 aufnimmt. Ausgehend von der Stufe 48 der Vertiefung erstrecken sich Rastmittel 52 senkrecht nach oben (Figur 4), die einen Schaft 54 und eine Nase 56 aufweisen. An den Nasen 56 ist eine Schräge 58 angeformt, die bewirkt, das beim Einsetzen des Transformators 22 der Schaft 54 leicht nach außen gebogen wird, der Transformator 22 nach unten bewegt werden kann und dann die Nase 56 an einer Schulter 60 zur Anlage gelangt bzw. einrastet. Im Ausführungsbeispiel sind zwei sich bezüglich der Vertiefung 48, 50 diametral gegenüberliegende Rastmittel 52 gezeigt, es können im Bedarfsfall jedoch auch mehrere solcher Rastmittel 52 vorgesehen sein.

Die Stufe 48 der Vertiefung enthält ferner federnde Elemente 62, die jeweils eine in Richtung der Rastmittel 52 weisende Lasche 64 in einer Öffnung 66 besitzen. Im eingebauten Zustand des Transformators 22 wird die Lasche 64 entsprechend der Größe des Transformators 22 in die Öffnung 66 gedrückt bzw. drückt ihrerseits den Transformator 22 gegen die Nasen 56 der Rastmittel 52. Auf diese Weise ist ein fester Einspannverbund erreicht, durch den einerseits Herstellungstoleranzen des Transformators ausgeglichen und Vibrationsgeräusche vermieden werden können.

Das erste Gehäuseteil 12 besitzt ferner Rastmittel 68 und Abstandshalter 70 zur Aufnahme der Schaltungsplatine 24. Die Rastmittel 68 weisen analog den Rastmitteln 52 einen Schaft, eine Nase und eine Schräge auf.

Die Schaltungsplatine 26, die senkrecht zur Schaltungsplatine 24 angeordnet und mit dieser über Steckkontakte verbunden ist, wird durch Führungsmittel 72 gehalten.

Eine vom Boden 46 ausgehende Wand 74 teilt einen Raum 76 ab, der eine Beleuchtungsvorrichtung 78 aufnimmt. Der Boden 46 weist dazu im äußeren Bereich des Raumes 76 eine Öffnung 80 auf, in die ein Sockel 82 mit Nasen 84 der Beleuchtungsvorrichtung 78 so eingepaßt sind, daß ein fester Halteverbund entsteht.

Auf der der Öffnung 80 gegenüberliegenden Seite des Raumes 76 ist eine weitere Öffnung 86 vorgesehen, die sich im Bereich des eingesetzten Leuchtmittels 85 befindet und durch die ein Wärmeaustausch stattfinden kann.

Das zweite Gehäuseteil 14 besitzt eine mit der Wand 74 korrespondierende Wand 88, so daß im zusammengesetzten Zustand der Raum 76 in sich geschlossen ist, bis auf die Öffnung 86 und ein Durchbruch 89 in der Wand 74 für die elektrische Zuleitung für die Beleuchtungsvorrichtung 78. Im Bereich der Beleuchtungsvorrichtung 78 ist das zweite Gehäuseteil 14 abgeschrägt und mit einem Deckel 90 versehen.

Der Deckel 90 ist im Bereich der Wand 38 an das zweite Gehäuseteil 14 einstückig angeformt, wobei der Übergangsbereich eine definierte Knickstelle 92, ein sogenanntes Filmscharnier, aufweist, wodurch der Deckel beweglich gehalten ist. Auf der der Knickstelle 92 gegenüberliegenden Seite des Deckels 90 ist in die Wand 88 ein Rastmittel 94 angeformt, bestehend aus Schaft, Nase und Schräge entsprechend den Rastmitteln 52. Mit diesen kann der Deckel 90 durch eine seinerseits angeformte Anlageschulter 96 zusammenwirken und gehalten werden.

Auf der der Schaltungsplatine 24 gegenüberliegenden Seite des Bodens 46 sind Endschalter 98 aus Draht 100 in Schlaufenform (Figur 7) angeordnet, die einen Kontaktbereich 101, einen Haltebereich 102 und einen Anschlußbereich 103 aufweisen.

Im Anschlußbereich 103 ist ein Drahtende durch die Schaltungsplatine 24 in ein Anschlußelement 104 eingeführt. Die Schaltungsplatine 24 liegt dazu auf Abstandshalter 106 und 106' auf, die gleichzeitig einen Teil des Haltebereiches 102 bilden.

Die Abstandshalter 106 werden vom Draht 100 passend durchdrungen und sind am Boden 46 einstückig angeformt. Der Draht 100 durchdringt auch den Boden 46 und ist dann geknickt, um in einem Führungselement 108 zur Anlage zu gelangen. Hinter dem Führungselement 108 ist der Draht nochmals geknickt und führt vom Boden 46 weg in den Kontaktbereich 101, von wo er schlaufenförmig zurück auf den Boden 46 geführt ist.

Dort ist der Draht wieder geknickt und verläuft parallel zum Boden 46, der in diesem Bereich hakenförmige Rastmittel 110 aufweist, die den Draht 100 passend umgreifen und halten. Hinter den Rastmitteln 110 ist der Draht 100 nochmals geknickt und durch den Boden 46 und einen Abstandshalter 106 spielfrei hindurchgeführt und gehalten.

Ein zweiter Draht 100' ist analog geformt und von einem Abstandshalter 106', einem Führungselement 108' und einem Rastmittel 110' gehalten und seitlich versetzt zum ersten Draht 100 angeordnet.

Werden die Drähte 100 und 100', beispielsweise durch einen nicht dargestellten Schaltungnocken, aufeinander gedrückt, so berühren sie sich im schlaufenförmigen Kontaktbereich 101, wodurch aufgrund der dort gebogenen Drahtform die beiden Drähte 100 und 100' beim Berühren aneinander Reiben und die Kontaktflächen auf diese Weise stets reinigen werden. Diese vorteilhafte Anordnung ermöglicht somit einen sicheren Kontakt, auch wenn mit Verschmutzung gerechnet werden muß.

Die vorgebogenen Drähte 100 werden montiert, in dem die Drähte 100 in die Abstandshalter 106 und die Führungselemente 108 eingeführt und dann durch leichtes Ausbiegen und seitliches Einschieben in die Rastmittel 110 befestigt werden. Die so gehaltenen Endschalter 98 können durch leichtes Anheben der Rastmittel 110 und inverser Schrittfolge einfach und ohne Werkzeug wieder demontiert werden. Es können mehrere solcher Endschalter 98 vorgesehen sein.

Auf der Seite der Endschalter 98 ist an den Boden 46 ein Führungskanal 112 parallel zur Längserstreckung des Gehäuseteils 12 angeformt. Dieser Führungskanal 112 ist auf der der stufenförmigen Vertiefung 48, 50 gegenüberliegenden Seite des ersten Gehäuseteils 12 offen, erstreckt sich bis ca. zur Mitte dieses Gehäuseteils 12 und nimmt entsprechend Figur 1 die Halteschiene 28 spielfrei auf.

In Verlängerung des Führungskanals 112 weist der Boden 46 eine kreisförmige Öffnung 114 und drei symmetrisch verteilte Öffnungen 116 auf. Durch die Öffnung 114 ist der Antrieb ausgehend vom Getriebe 18 für das Kettenritzel 20 passgenau geführt und durch die Öffnungen 116 mittels Schrauben 118 befestigt. Auch diese Anordnung bzw. Befestigung könnte durch Rastmittel erfolgen, jedoch muß sichergestellt sein, daß die auftretenden Kräfte und die vom Motor 16 über das Kettenritzel 20 auf die nicht dargestellte Kette übertragenden Drehmomente diese Befestigung auch bei wechselnden Belastungen nicht lösen.

Der Aufbau gemäß dem Ausführungsbeispiel mit dem Führungskanal 112 und den geschraubten Antriebselementen gewährleisten ein hohes Maß an Stabilität und Übertragungssicherheit bezüglich der auftretenden Kräfte und Drehmomente.

Am Sockel 30 sind mehrere Langlöcher 120 längs und quer so eingebracht, daß eine einfache Montage des Gehäuseteils an eine Wand, Decke oder dergleichen möglich ist. Ferner durchdringen weitere Löcher 122 den Sockel quer zu den Langlöchern 120. An diesen Löchern 122 lassen sich bevorzugt Winkelschienen oder ähnliches befestigen, wodurch die Montage den örtlichen Gegebenheiten angepaßt werden kann.

Die Wände 32 weisen Aussparungen 124 auf, vorzugsweise im Bereich der Schaltungsplatine 24, durch die Anschlüsse auch bei geschlossenem Gehäuse 10 nach außen geführt werden können. Solche Anschlüsse können beispielsweise die Kontaktstelle zu einer weiteren Beleuchtungsvorrichtung oder zu einem im Gehäuse integrierten Batterieladegerät darstellen. Ferner können die Öffnungen einen Zugriff zu Sicherungen und Drehpotentiometer oder ähnlichem zum Einstellen elektrischer Schaltungsgrößen erlauben.

Es können weitere Rastmittel im Gehäuse vorgesehen sein, die beispielsweise durch weitere Öffnungen eingeführte Kabel passend aufnehmen und arretieren.

Das Gehäuse ist vorzugsweise aus einem thermoplastischem Kunststoff als Spritzgußteil hergestellt.

## Patentansprüche

1. Gehäuse zum Aufnehmen eines elektrischen Garagentorantriebes und dessen Steuerung, das mindestens zwei Gehäuseteile aufweist, dadurch gekennzeichnet, daß die Gehäuseteile (12, 14) Rastmittel (34, 52, 68, 110) und Führungselemente (108, 112) zum sicheren Verbinden der Gehäuseteile (12, 14) sowie zum Einrasten und Halten wenigstens eines Funktionsbauteils (22, 28, 78) und wenigstens einer Platine (24, 26) für die Steuerung aufweisen.

2. Gehäuse nach Anspruch 1, dadurch gekennzeichnet, daß die Rastmittel (34) innerhalb des Gehäuses (10) ineinander greifen und mindestens ein Gehäuseteil (12) Öffnungen (36) im Bereich der Rastmittel (34) aufweist, durch die diese mittels eines Werkzeuges entriegelbar sind.

3. Gehäuse nach Anspruch 1 oder 2, dadurch gekennzeichnet, daß an dem die Funktionsbauteile (22) aufnehmenden Gehäuseteil (12) federnde Elemente (62) angeformt sind, die die Funktionsbauteile (22) im eingebauten Zustand gegen die Rastelemente (52) drücken.

4. Gehäuse nach einem der Ansprüche 1 bis 3, dadurch gekennzeichnet, daß ein Gehäuseteil (12) Langlöcher (120) zum direkten Befestigen des Gehäuses (10) an einer Wand, Decke oder dergleichen und quer zu den Langlöchern (120) weitere Löcher (122) zum indirekten Befestigen, insbesondere mittels Abstandsschienen, aufweist.

5. Gehäuse nach einem der Ansprüche 1 bis 4 mit einer innerhalb des Gehäuses angeordneten Beleuchtungsvorrichtung, dadurch gekennzeichnet, daß ein Gehäuseteil (14) einen lichtdurchlässigen, mit dem Gehäuseteil (14) drehbar oder schwenkbar verbundenen und einrastbaren Deckel (90) aufweist, durch den das Leuchtmittel (85) der Beleuchtungsvorrichtung (78) auswechselbar ist.

6. Gehäuse nach einem der Ansprüche 1 bis 5, dadurch gekennzeichnet, daß ein Gehäuseteil (12) Endschalter (98) in Form von Drahtschlaufen (100) aufnimmt, die in das Gehäuseteil (12) und/oder das Funktionsbauteil (22, 28, 78) und/oder die Platine (24, 26) einrastbar sind und die mit der in dem Gehäuseteil (12) anordenbaren Platine (24) elektrisch direkt verbindbar sind.

7. Gehäuse nach Anspruch 6, dadurch gekennzeichnet, daß die Drahtschlaufen (100) der Endschalter (98) beim Schließen des Kontaktes eine reibende Bewegung ausführen.

8. Gehäuse nach einem der vorhergehenden Ansprüche, dadurch gekennzeichnet, daß Aussparungen (124) vorgesehen sind, durch die bei geschlossenem Gehäuse (10) verwendbare Anschlüsse nach außen führbar sind.

## Claims

1. Housing for receiving an electric garage-door drive and the control means thereof, which housing exhibits at least two housing parts, characterized in that the housing parts (12, 14) exhibit latching means (34, 52, 68, 110) and guide elements (108, 112) for the reliable connection of the housing parts (12, 14) and for latching-in and retaining at least one functional component (22, 28, 78) and at least one circuit board (24, 26) for the control means.

2. Housing according to Claim 1, characterized in that the latching means (34) engage one in the other within the housing (10) and at least one housing part (12) exhibits openings (36) in the region of the latching means (34), through which openings said latching means can be unlocked by means of a tool.

3. Housing according to Claim 1 or 2, characterized in that resilient elements (62) are integrally formed on the housing part (12) which receives the functional components (22), which resilient elements press the functional components (22), in the installed state, against the latching elements (52).

4. Housing according to one of Claims 1 to 3, characterized in that a housing part (12) exhibits slots (120) for the direct fastening of the housing (10) on a wall, ceiling or the like and, transversely with respect to the slots (120), exhibits further holes (122) for indirect fastening, in particular by means of spacer rails.

5. Housing according to one of Claims 1 to 4 having a lighting device arranged within the housing, characterized in that a housing part (14) exhibits a translucent cover (90) which is connected rotatably or pivotably to, and can be latched in, the housing part (14) and by way of which the lighting means (85) of the lighting device (78) can be exchanged.

6. Housing according to one of Claims 1 to 5, characterized in that a housing part (12) receives limit switches (98) in the form of wire loops (100) which can be latched into the housing part (12) and/or the functional component (22, 28, 78) and/or the circuit board (24, 26) and can be directly connected in electrical terms to the circuit board (24) which can be arranged in the housing part (12).

7. Housing according to Claim 6, characterized in that the wire loops (100) of the limit switches (98), upon closure of the contact, carry out a rubbing movement.

8. Housing according to one of the preceding claims, characterized in that provision is made for clearances (124) through which connections which can be used when the housing (10) is closed can be led to the outside.

## Revendications

1. Boîtier pour recevoir un système d'entraînement électrique de porte de garage et sa commande, qui présente au moins deux parties de boîtier, boîtier
caractérisé en ce que
les parties du boîtier (12, 14) présentent des moyens d'enclenchement (34, 52, 68, 110) et des éléments de guidage (108, 112) qui servent à relier de façon sûre les parties du boîtier (12, 14) et à enclencher et fixer au moins un composant fonctionnel (22, 28, 78) et au moins une platine de montage(24, 26) pour la commande.

2. Boîtier selon la revendication 1,
caractérisé en ce que
les organes d'enclenchement (34) viennent en prise les uns dans les autres à l'intérieur du boîtier (10) et en ce qu'au moins une partie du boîtier (12) présente des orifices (36) dans la zone des moyens d'enclenchement (34), grâce auxquels on peut verrouiller ceux-ci au moyen d'un outil.

3. Boîtier selon la revendication 1 ou 2,
caractérisé en ce que
sur la partie du boîtier (12) qui reçoit les composants fonctionnels (22) sont formés des éléments qui font ressort (62), qui pressent les composants fonctionnels (22), en position montée, contre les éléments d'enclenchement (52).

4. Boîtier selon l'une des revendications 1 à 3,
caractérisé en ce que
une partie du boîtier (12) présente des trous oblongs (120) servant à fixer directement le boîtier (10) sur une paroi, un plafond ou analogue et perpendiculairement aux trous oblongs (120) d'autres trous (122) servant à une fixation indirecte, en particulier au moyen d'écarteurs.

5. Boîtier selon l'une des revendications 1 à 4, avec un dispositif d'éclairage disposé à l'intérieur du boîtier, boîtier,
caractérisé en ce que
une partie du boîtier (14) présente un couvercle (90) transparent, relié de façon à pouvoir tourner ou pivoter à la partie du boîtier (14) et pouvant s'enclencher, grâce auquel on peut changer le moyen d'éclairage (85) du dispositif d'éclairage (78) .

6. Boîtier selon l'une des revendications 1 à 5,
caractérisé en ce que
une partie du boîtier (12) reçoit un interrupteur de fin de course (98) sous la forme de boucles de câbles (100) que l'on peut enclencher dans la partie du boîtier (12) et/ou le composant fonctionnel (22, 28, 78) et/ou la platine de montage (24, 26) et qui peuvent être reliés directement de façon électrique à la platine de montage (24) qui peut être disposée dans la partie du boîtier (12).

7. Boîtier selon la revendication 6,
caractérisé en ce que
les boucles de câbles (100) des interrupteurs de fin de course (98) effectuent lors de la fermeture du contact, un mouvement de frottement.

8. Boîtier selon l'une des revendications précédentes,
caractérisé en ce que
des évidements (124) sont prévus, à travers lesquels on peut faire passer, quand le boîtier est fermé, des raccords utilisables.
